## Europäisches Patentamt
## European Patent Office
## Office européen des brevets

(11) Veröffentlichungsnummer: **0 166 027**
**B1**

(12) **EUROPÄISCHE PATENTSCHRIFT**

(45) Veröffentlichungstag der Patentschrift: **13.06.90**

(51) Int. Cl.⁵: **H 01 L 27/02, H 01 L 23/52**

(21) Anmeldenummer: **84115074.1**

(22) Anmeldetag: **10.12.84**

(54) In C-MOS-Technik realisierte Basiszelle.

(30) Priorität: **19.06.84 DE 3422715**

(43) Veröffentlichungstag der Anmeldung:
**02.01.86 Patentblatt 86/01**

(45) Bekanntmachung des Hinweises auf die
Patenterteilung:
**13.06.90 Patentblatt 90/24**

(84) Benannte Vertragsstaaten:
**AT CH DE FR GB IT LI**

(56) Entgegenhaltungen:
**EP-A-0 023 818**
**US-A-4 240 094**

(73) Patentinhaber: **Siemens Aktiengesellschaft**
**Wittelsbacherplatz 2**
**D-8000 München 2 (DE)**

(72) Erfinder: **Schallenberger, Burghardt, Dr. Dipl.-Phys.**
**Brunnenweg 9a**
**D-8152 Feldolling (DE)**
Erfinder: **Stockinger, Josef, Dipl.-Ing.**
**Schleissheimerstrasse 231**
**D-8000 München 40 (DE)**
Erfinder: **Fuchs, Paul, Cand.-Phys.**
**Am Nergel**
**D-8702 Leinach (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

## Beschreibung

Die Erfindung bezieht sich auf eine in C-MOS Technik realisierte Basiszelle zum Aufbau von elektrischen Schaltkreisen.

Die steigende Komplexität von höchstintegrierten elektrischen Schaltkreisen macht den Handentwurf des Schaltungslayouts zunehmend schwieriger. Die große Anzahl der geometrischen Einzelstrukturen einer VLSI-Schaltung erzwingt den Übergang zur automatischen Layoutgenerierung. Bei einem solchen Layoutgenerierungsverfahren werden die geometrischen Layoutstrukturen mit Hilfe von Software aus einer abstrakten Schaltungsbeschreibung gewonnen. Dabei werden die einzelnen Layoutrechtecke durch ein Programm dimensioniert und plaziert. Besondere Vorteile einer Layouterzeugung per Software sind hohe Flexibilität, schnelle Anpassung an neue Entwurfsregeln und kurze Entwurfszeiten.

Das Gesamtlayout einer elektronischen Schaltung wird aus einer Vielzahl von solchen Layoutrechtecken gebildet. Beim personellen Entwurf der elektronischen Schaltung wird jedes Rechteck einzeln dimensioniert und individuell plaziert. Bei einem solchen Verfahren wird jedoch die Komplexität nicht reduziert, so daß Layouts von größeren Schaltungen nur mit großem Aufwand erzeugt werden können. Das Gate-Matrix-Verfahren hingegen reduziert die Komplexität des Schaltungsentwurfs, da für die Plazierung der geometrischen Strukturen nur bestimmte Rasterpunkte einer Matrix zugelassen werden. Nach dem Gate-Matrix-Prinzip werden Layouts im Umfang von Standardzellen erzeugt und anschließend mit herkömmlichen Methoden weiter verarbeitet. Ein anderes Verfahren zur automatischen Layouterzeugung auch von umfangreichen VLSI-Schaltungen reduziert die Komplexität des Schaltungsentwurfs mit Hilfe des Basiszellenkonzepts. Dabei wird ein Layout aus im hohen Maße parametrisierten Basiszellen aufgebaut. Innerhalb einer Basiszelle ist die relative Anordnung einzelner geometrischer Strukturen zueinander vorgegeben. Weitere Verfahren zur Herstellung von elektronischen Schaltkreisen können z.B. der Broschüre CAD für VLSI von H. G. Schwärtzel, Springer-Verlag 1982, z.B. S. 63—76, entnommen werden.

Aus der US—A—4 240 094 ist ein integrierter Schaltkreis bekannt, der aus Zellen besteht. Die Zellen enthalten Subzellen, die eine derartige Struktur haben, daß ihnen unter Verwendung eines Lasers unterschiedliche Funktionen gegeben werden können. Die Subzellen können als Inverter oder als Leiterbahn konfiguriert werden. Weiterhin enthalten die Zellen logische Glieder, über die die Ausgangssignale der Subzellen zusammengefaßt werden. Die Zellen können nebeneinander angeordnet werden. Der Inverter besteht aus einem CMOS, in dem zwei Transistoren entgegengesetzten Leitungstyps nebeneinander angeordnet sind. Erste Polysilizium Leiterbahnen erstrecken sich parallel zu den Transistoren, während zweite Leiterbahnen, im wesentlichen aus Metall sich senkrecht zu den ersten Leiterbahnen erstrecken und über die Transistoren verlaufen.

Die der Erfindung zugrundeliegende Aufgabe besteht darin, einen integrierten Schaltkreis mit Basiszellen aufzubauen, die eine hohe Verdrahtungsflexibilität erlauben und damit die Realisierung unterschiedlichster Funktionen. Diese Aufgabe wird gemäß den Merkmalen des Anspruchs 1 gelöst.

Mit der angegebenen Anordnung der Leiterbahnen im Verhältnis zu den Transistoren läßt sich jede sinnvolle zellenterne Verdrahtung und Anschlußführung an den Zellenrand realisieren, ohne daß sich die relativen Lagen der geometrischen Strukturen entscheidend verändern.

Um ohne Beeinflussung der Zellenbreite die Transistorweite variieren zu können, ist es zweckmäßig, das Gate der Transistoren parallel zu den zweiten Leiterbahnen anzuordnen.

Es ist zweckmäßig, die Versorgungsleitungen als zweite Leiterbahnen über die Diffusionsgebiete der Transistoren zu führen und zwar zwischen dem Gate des jeweiligen Transistors und dem Zellenrand. Dann kann ein eventuell erforderlicher Kontakt zwischen einer Versorgungsleitung und einer Transistorelektrode mit Hilfe eines Langkontaktes erfolgen, der gleichzeitig das Substrat bzw. die p-Wanne kontaktiert.

Um möglichst geringe Elektrodenkapazitäten zu erreichen, ist die Ausdehnung von Source und Drain der Transistoren möglichst klein. Zum Beispiel ist die Ausdehnung der zur Zellenmitte weisenden Transistorelektrode der Transistoren gerade so groß wie zur Aufnahme eines Kontaktes erforderlich ist. Die zum Zellenrand orientierte Transistorelektrode, die nicht mit einer Versorgungsleitung verbunden ist, ist gerade so groß, wie es zur Umgehung der Versorgungsleitung und zur Kontaktierung mit einer zweiten Leiterbahn notwendig ist.

Geringe Anschlußwiderstände der Transistoren werden dadurch erreicht, daß der Anschluß von Drain und Source der Transistoren an eine zweite Leiterbahn, eine Metalleitung, über mehrere Kontakte hergestellt wird. Dies ist durch die parallele Anordnung der Gates der Transistoren und der Metallbahn möglich.

Ein weiterer Vorteil der erfindungsgemäßen Basiszelle besteht darin, daß die ersten Leiterbahnen aus Polysilizium, die zum Anschluß für die Gateelektroden der Transistoren dienen, oberhalb oder unterhalb der Diffusionsgebiete angeordnet sein können.

Anhand von Ausführungsbeispielen wird die Erfindung weiter erläutert. Es zeigen

Fig. 1 ein Layout der erfindungsgemäßen Basiszelle,

Fig. 2 ein Layout einer bistabilen Kippschaltung (Latch) unter Verwendung von Basiszellen,

Fig. 3 das Schaltbild der bistabilen Kippschaltung nach Fig. 2.

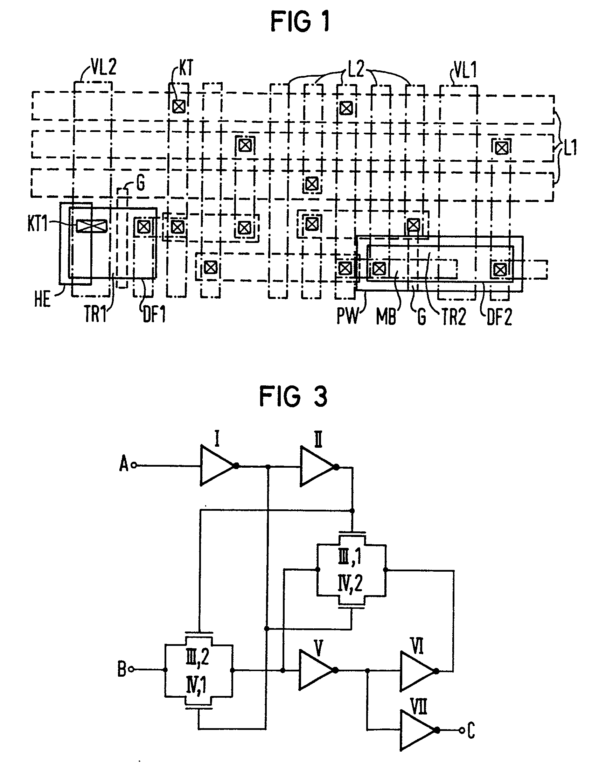

Aus Fig. 1 kann der Aufbau der Basiszelle entnommen werden. In der Darstellung ist dabei Metall strichpunktiert, Polysilizium gestrichelt, Diffusionsgebiete, p-Wanne und Implantationen ausgezogen dargestellt.

Die Basiszelle umfaßt zwei Transistoren TR1 und TR2. Dabei enthält der Transistor TR1 ein Diffusionsgebiet DF1 mit Akzeptordotierung, der Transistor TR2 ein Diffusionsgebiet DF2 mit Donatordotierung, das von einer p-Wanne PW umgeben ist.

Die Basiszelle weist weiterhin erste Leiterbahnen L1 und zweite Leiterbahnen L2 auf. Die ersten Leiterbahnen L1 bestehen im wesentlichen aus Polysilizium, die zweiten Leiterbahnen L2 bestehen im wesentlichen aus Metall. Die ersten Leiterbahnen L1 und die zweiten Leiterbahnen L2 sind senkrecht zueinander angeordnet. Dabei verlaufen die zweiten Leiterbahnen L2 entweder zwischen den beiden Transistoren TR1 und TR2 oder sie sind über das Diffusionsgebiet der Transistoren TR1 und TR2 geführt. Die ersten Leiterbahnen L1 verlaufen im wesentlichen auf der einen Seite der Erstreckung der Transitoren TR1 und TR2 bzw. zwischen den Transistoren TR1 und TR2. Auf diese Weise wird zwischen den Transistoren TR1 und TR2 ein Verdrahtungskanal gebildet, über dessen Leiterbahnen die Transistoren TR1 und TR2 miteinander und zu Anschlüssen am Zellenrand verbunden werden können.

Um ohne Beeinflussung der Zellenbreite die Transistorweite variieren zu können, sind die Gates G der Transistoren TR1 und TR2 parallel zu den zweiten Leiterbahnen L2 geführt. Sie sind mit einer benachbart geführten ersten Leiterbahn L1 verbunden. Die weiteren Elektroden der Transistoren TR1 und TR2, Source und Drain, sind über Kontakte KT mit zweiten Leiterbahnen verbunden.

Die Leiterbahnen für die Spannungsversorgung VL1 und VL2, also die VDD- und VSS-Versorgungsleitungen, sind zwischem dem Gate G der Transistoren TR1 und TR2 und dem Zellenrand angeordnet. Soll dabei eine elektrische Verbindung zwischen einer Versorgungsleitung, z.B. der Versorgungsleitung VL2, und einer Transistorelektrode z.B. des Transistors TR1 erfolgen, dann ist es zweckmäßig, den entsprechenden Kontakt als Langkontakt KT1 auszuführen. Mit diesem Langkontakt KT1 kann über ein Implantationsgebiet HE gleichzeitig eine Verbindung mit dem Substrat bzw. mit einer p-Wanne hergestellt werden. Soll dagegen eine innenliegende Transistorelektrode mit der Versorgungsleitung kontaktiert werden, z.B. mit der Versorgungsleitung VL1, dann wird eine Metallbrücke MB über das Gate G, z.B. des Transistors TR2 von der Versorgungsleitung VL1 zur Transistorelektrode geführt.

Geringe Elektrodenkapazitäten werden dadurch erreicht, daß die Ausdehnung der Transistorelektroden möglichst klein gewählt werden, und zwar nur so groß, wie es zur Aufnahme eines Kontaktes KT erforderlich ist. Dies ist im Ausführungsbeispiel der Fig. 1 besonders bei den nach innen weisenden Transistorelektroden realisiert. Bei der nach außen weisenden Transistorelektrode eines Transistors, z.B. TR2, der nicht mit der Versorgungsleitung kontaktiert ist, muß die Transistorelektrode so groß gewählt werden, wie es zur Untertunnelung der Versorgungsleitung und zur Aufnahme eines Kontaktes notwendig ist. Der Transistor TR2 zeigt die entsprechende Lösung.

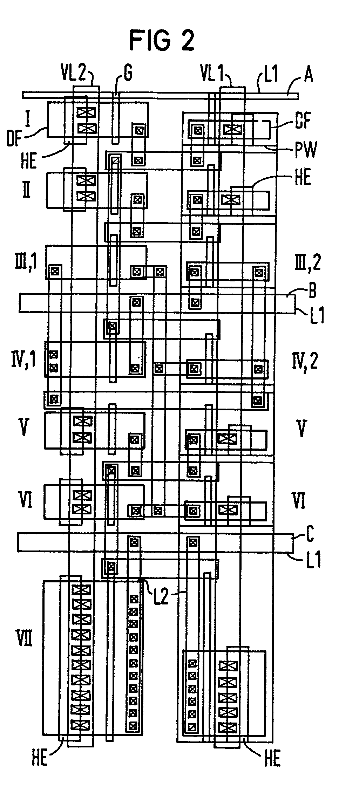

Die Basiszelle nach Fig. 1 weist eine besonders hohe Verdrahtungsflexibilität auf. Es ist sowohl die elektrische Verbindung zwischen den Transistorelektroden der beiden Transistoren TR1 und TR2 über Leitungen L1 und Leitungen L2 als auch die Verbindung dieser Transistorelektroden zum Zellenrand über Leitungen L1 und L2 möglich. Weiterhin können die Leitungen L1 und L2 in gewünschtem Maße miteinander verbunden werden. Durch Nebeneinanderanordnung einer Mehrzahl solcher Basiszellen und durch entsprechende elektrische Verbindung der Transistoren der Basiszellen können dann Schaltkreise aufgebaut werden. Ein Beispiel eines solchen Schaltkreises zeigen Fig. 1 und Fig. 2.

In Fig. 3 ist das elektrische Schaltbild dargestellt, das eine bistabile Kippschaltung zeigt, deren Rückkopplung auftrennbar ist. Diese bistabile Kippschaltung wird auch Latch genannt. Die einzelnen Basiszellen, die zum Aufbau des Schaltkreises verwendet werden, sind mit römischen Ziffern angegeben, die in Fig. 2 wieder auftreten. Der Schaltkreis besteht somit nach Fig. 2 und Fig. 3 aus einem ersten Inverter I, der mit einem Eingang A verbunden ist und dessen Ausgang an einen zweiten Inverter II angeschlossen ist. Die Ausgänge der Inverter I und II sind mit Basiszellen III und IV in der in Fig. 3 dargestellten Weise verbunden. Die einzelnen Transistoren der Basiszellen III und IV liegen mit ihren gesteuerten Strecken entsprechend Fig. 3 parallel zueinander, ihre Gateanschlüsse sind mit dem Ausgang jeweils des Inverters I und II verbunden. Weiterhin sind Inverter V und VI vorgesehen, die jeweils eine Basiszelle umfassen und ein Treiber VII, der ebenfalls als eine Basiszelle realisiert ist. Der Ausgang wird von der Leitung C gebildet.

In der bistabilen Kippschaltung gemäß Fig. 3 wird ein am Eingang B anliegender binärer Wert gespeichert, wenn ein Signal am Eingang A anliegt. Dieser binäre Wert kann am Ausgang C abgenommen werden.

Aus Fig. 2 kann entnommen werden, wie die Verbindung der einzelnen Basiszellen bzw. der Transistoren der einzelnen Basiszellen über erste Leiterbahnen L1 und zweite Leiterbahnen L2 erfolgt. Dabei sind die zweiten Leiterbahnen entweder zwischen den Transistoren der Basiszellen angeordnet oder verlaufen z.B. als Versorgungsleitungen VL1 und VL2 über die Diffusionsgebiete der Transistoren der Basiszellen. Es ist weiterhin der Fig. 2 zu entnehmen, daß die Kontakte zwischen den Versorgungsleitungen VL1 oder VL2 und den Transistorelektroden als Langkontakte ausgeführt sind, die über Implantationsbereiche HE gleichzeitig mit dem Substrat oder der p-Wanne verbunden sind. Weiterhin ist erkennbar, daß zur Reduzierung der Anschlußwiderstände der Transistoren pro Transistor mehrere Kontakte vorgesehen sein können. Dies wird insbesondere durch die parallele Anordnung der Transistorgates mit den zweiten Leiterbahnen L2 erreicht.

In der Darstellung der Fig. 2 sind die einzelnen Leiterbahnen L1 und L2 und die übrigen Gebiete, wie Diffusionsgebiete, p-Wanne und Implantationsgebiete, ausgezogen dargestellt.

**Patentansprüche**

1. Integrierter Schaltkreis mit in CMOS-Technik realisierten Basiszellen mit folgenden Merkmalen:

Die Basiszellen enthalten zwei nebeneinander angeordnete Transistoren (TR1, TR2), parallel zur Erstreckung der Transistoren verlaufende, oberhalb oder unterhalb der Diffusionsgebiete angeordnete, aus Polysilizium bestehende erste Leiterbahnen (L1) und senkrecht zu den ersten Leiterbahnen entweder über die Transistoren oder zwischen den Transistoren verlaufende, aus Metall bestehende zweite Leiterbahnen (L2), die Basiszellen sind senkrecht und oder in Richtung zur Erstreckung der Transistoren der Basiszellen nebeneinander angeordnet, so daß die Verbindung der senkrecht liegenden Basiszellen mit den zweiten Leiterbahnen (L2), die Verbindung der in Richtung der Erstreckung der Transistoren liegenden Basiszellen über die ersten Leiterbahnen (L1) hergestellt ist.

2. Basiszelle nach Anspruch 1, dadurch gekennzeichnet, daß das Gate (G) der Transistoren (TR1, TR2) parallel zu den zweiten Leiterbahnen (L2) angeordnet ist.

3. Basiszelle nach Anspruch 1 oder 2, dadurch gekennzeichnet, daß die ersten Leiterbahnen (L1) auf der einen Seite der Erstreckung der Transistoren (TR1, TR2) angeordnet sind.

4. Basiszelle nach einem der vorhergehenden Ansprüche, dadurch gekennzeichnet, daß die Versorgungsleitungen (VL1, VL2) zweite Leiterbahnen (L2) sind, die über die Diffusionsgebiete der Transistoren (TR1, TR2) geführt sind und jeweils zwischen dem Gate (G) und dem Zellenrand verlaufen.

5. Basiszelle nach Anspruch 4, dadurch gekennzeichnet, daß eine elektrische Verbindung zwischen einer innenliegenden Elektrode eines Transistors (TR2) und einer über das Diffusionsgebiet des Transistors geführten Versorgungsleitung (VL1) durch eine über das Gate gelegte Metallbrücke (MB) erfolgt.

6. Basiszelle nach Anspruch 4 oder 5, dadurch gekennzeichnet, daß eine elektrische Verbindung zwischen einer Versorgungsleitung (VL2) und einer benachbart liegenden Transistorelektrode über einen Langkontakt (KT1) erfolgt, der gleichzeitig das Substrat bzw. eine p-Wanne kontaktieren kann.

7. Basiszelle nach einem der vorhergehenden Ansprüche, dadurch gekennzeichnet, daß die nach innen weisenden Elektroden eines Transistors (TR1, TR2) gerade die Größe haben, die zur Aufnahme eines Kontaktes (KT) erforderlich ist.

8. Basiszelle nach einem der Ansprüche 4 bis 7, dadurch gekennzeichnet, daß die zum Zellenrand weisende nicht mit einer Versorgungsleitung (VL1, VL2) verbundene Transistorelektrode eines Transistors (TR2) maximal die Ausdehnung hat, die zur Umgehung der Versorgungsleitung (VL1) und zur Kontaktierung mit einer zweiten Leiterbahn erforderlich ist.

9. Basiszelle nach einem der vorhergehenden Ansprüche, dadurch gekennzeichnet, daß der Anschluß der Transistorelektroden Source und Drain an zweite Leiterbahnen (L2) über mehrere Kontakte erfolgt.

**Revendications**

1. Circuit intégré comportant des cellules de base réalisées selon la technique CMOS et présentant les caractéristiques suivantes:

les cellules de base contiennent deux transistors (TR1, TR2) disposés côte-à-côte, des premières voies conductrices (L1) réalisées en polysilicium, qui sont parallèles à l'étendue des transistors et sont disposées au-dessus ou au-dessous des régions de diffusion, et des secondes voies conductrices (L2) réalisées en un métal, qui s'étendent perpendiculairement aux premières voies conductrices, soit au-dessus des transistors, soit entre les transistors, les cellules de base sont disposées perpendiculairement à ou dans la direction de l'étendue des transistors des cellules de base de sorte que la liaison entre les cellules de base perpendiculaires sont formies avec les secondes voies conductrices (L2) et la liaison des cellules de base, qui s'étendent dans la direction dans laquelle s'étendent les transistors, sont formées par l'intermédiaire des premières voies conductrices (L1).

2. Cellule de base suivant la revendication 1, caractérisée par le fait que la grille (G) des transistors (TR1, TR2) est parallèle aux secondes voies conductrices (L2).

3. Cellule de base selon la revendication 1 ou 2, caractérisée en ce que les premières voies conductrices (L1) sont disposées d'un côté de la zone d'extension des transistors (TR1, TR2).

4. Cellule de base suivant l'une des revendications précédentes, caractérisée par le fait que les conducteurs d'alimentation (VL1, VL2) sont des secondes voies conductrices (L2), qui s'étendent au-dessus des régions de diffusion des transistors (TR1, TR2) et s'étendent respectivement entre la grille (G) et le bord de la cellule.

5. Cellule de base suivant la revendication 4, caractérisée par le fait qu'une liaison électrique entre une électrode intérieure d'un transistor (TR2) et un conducteur d'alimentation (VL1) s'étendant au-dessus de la région de diffusion du transistor, est realisée par un étrier métallique (MB) disposé au-dessus de la grille.

6. Cellule de base suivant la revendication 4 ou 5, caractérisée par le fait qu'une liaison électrique entre un conducteur d'alimentation (VL2) et une électrode d'un transistor, située au voisinage, est réalisée par l'intermédiaire d'un long contact (KT1), qui peut être simultanément en contact avec le substrat et avec une cuvette de type p.

7. Cellule de base suivant l'une des revendications précédentes, caractérisée par le fait que les électrodes, dirigées vers l'intérieur, d'un transistor (TR1, TR2) possèdent exactement la taille nécessaire pour la réception d'un contact (KT).

8. Cellule de base suivant l'une des revendications 4 à 7, caractérisée par le fait que l'électrode d'un transistor (TR2), qui est tournée vers le bord de la cellule et n'est pas reliée à un conducteur d'alimentation (VL1, VL2), possède au maximum l'étendue nécessaire pour contourner le conducteur d'alimentation (VL1) et établir un contact avec une seconde voie conductrice.

9. Cellule de base suivant l'une des revendications précédentes, caractérisée par le fait que le raccordement des électrodes du transistor, constituées par la source et le drain, aux secondes voies conductrices (L2) est réalisé par l'intermédiaire de plusieurs contacts.

**Claims**

1. Integrated circuit with C-MOS technology base cells having the following features:

The base cells contain two transistors (TR1, TR2) disposed side-by-side, first interconnects (L1) which are composed of polysilicon, run parallel to the side edge of the transistors and are disposed above or below the diffusion regions, and, perpendicular to the first interconnects, second interconnects (L2) which are composed of metal and run either above the transistors or between the transistors, the base cells are disposed side-by-side perpendicular to and/or in the direction of the side edge of the transistors of the base cells in such a way that the connection of the perpendicular base cells is produced via the second interconnects (L2), and the connection of the base cells lying in the direction of the side edge of the transistors is produced via the first interconnects (L1).

2. Base cell according to Claim 1, characterized in that the gate (G) of the transistors (TR1, TR2) is disposed parallel to the second interconnects (L2).

3. Base cell according to Claim 1 or 2, characterized in that the first interconnects (L1) are disposed on the same side edge of the transistors (TR1, TR2).

4. Base cell according to one of the preceding claims, characterized in that the supply lines (VL1, VL2) are second interconnects (L2) which are conducted over the diffusion regions of the transistors (TR1, TR2) and in each case run between the gate (G) and the cell edge.

5. Base cell according to Claim 4, characterized in that an electrical connection between an inner electrode of a transistor (TR2) and a supply line (VL1) conducted over the diffusion region of the transistor is effected by means of a metal bridge (MB) placed over the gate.

6. Base cell according to Claim 4 or 5, characterized in that an electrical connection between a supply line (VL2) and an adjacent transistor electrode is effected via a long contact (KT1), which can at the same time contact the substrate or a p-tub.

7. Base cell according to one of the preceding claims, characterized in that the inwardly directed electrodes of a transistor (TR1, TR2) are just as large as required for the acceptance of a contact (KT).

8. Base cell according to one of Claims 4 to 7, characterized in that the transistor electrode of a transistor (TR2) directed towards the cell edge and not connected to a supply line (VL1, VL2) at most has the extent required for bypassing the supply line (VL1) and for contacting a second interconnect.

9. Base cell according to one of the preceding claims, characterized in that the connection of the source and drain transistor electrodes to second interconnects (L2) is effected via a plurality of contacts.

# FIG 1

VL2      KT                L2           VL1

L1

G

KT1

HE      TR1    DF1               PW  MB  G  TR2  DF2

# FIG 3

A o——▷ I ——▷ II

III,1
IV,2

B o—— III,2
IV,1

V ——▷ VI ——▷

VII ——o C

# FIG 2